# EUROPEAN PATENT SPECIFICATION

(11) **EP 1 856 224 B1**
(45) Date of publication and mention of the grant of the patent: **10.08.2011**
(21) Application number: 05822837.0
(22) Date of filing: 30.12.2005
(51) Int. Cl.: C09K 3/14

(54) **POLISHING SLURRY COMPOSITION FOR IMPROVING SURFACE QUALITY OF SILICON WAFER AND METHOD FOR POLISHING SILICON WAFER USING THE SAME**
POLIERSUSPENSIONSZUSAMMENSETZUNG ZUR VERBESSERUNG DER OBERFLÄCHENGÜTE EINES SILICIUMWAFERS UND VERFAHREN ZUM POLIEREN EINES SILICIUMWAFERS DAMIT
COMPOSITION DE BOUE DE POLISSAGE PERMETTANT D'AMELIORER LA QUALITE DE SURFACE D'UNE PLAQUETTE EN SILICIUM, ET METHODE POUR POLIR UNE PLAQUETTE EN SILICIUM AU MOYEN DE LADITE COMPOSITION

(30) Priority: 07.03.2005 KR 20050018492
(43) Date of publication of application: 21.11.2007
(73) Proprietor: CHEIL INDUSTRIES INC., Gumi-si Gyeongsangbuk-do 730-710 (KR); MEMC KOREA CO., LTD., Chunan-si Choongcheongnam-do 330-831 (KR)
(72) Inventor: ROH, Hyun Soo, Gunpo-si, Gyeonggi-do 435-040 (KR); PARK, Tae Won, Jangan-gu, Suwon-si, Gyeonggi-do 440-200 (KR); LEE, Tae Young, Gunpo-si, Gyeonggi-do 435-010 (KR); LEE, In Kyung, Euiwang-si, Gyeonggi-do 437-080 (KR); LEE, Chin Ho, Chunan-si, Choongcheongnam-do 330-090 (KR); KIM, Young Woo, Chunan-si, Choongcheongna-do 330-090 (KR); CHOI, Moon Ro, Chunan-si, Choongcheongnam-do 330-090 (KR); KIM, Jongt Seop, Chunan-si, Choongcheongnam-do 330-090 (KR)
(74) Representative: Fiammenghi, Carlo
(86) International application number: PCT/KR2005/004655
(87) International publication number: WO 2006/095958

(56) References cited:
- WO-A1-2004/042812
- WO-A1-2004/042812
- WO-A2-2004/101221
- JP-A- 2000 173 956
- KR-A- 20000 038 383
- US-A1- 2002 151 252
- US-B1- 6 569 216

## Description

### Technical Field

The present invention relates to a slurry composition for markedly decreasing the number of surface defects formed on a silicon wafer, thereby reducing the surface microroughness and haze of the silicon wafer.

### Background Art

Silicon wafers are used as substrates for manufacturing semiconductors. Silicon wafers are produced through a series of processes, such as single crystal growth, slicing, lapping, etching, polishing and cleaning. Of these processes, polishing is a process for removing surface defects and subsurface defects formed in the previous processes, including scratches, splits, grain distortion, surface microroughness, surface topographical defects, etc., to produce defect-free wafers with a specular surface.

Chemical mechanical polishing (CMP), which is a final process for the production of silicon wafers, is performed to remove physical surface defects, such as microscratches, and to lower the surface microroughness, thus making the surface of wafers soft. Wafers passing through the CMP process have specular surfaces with few defects. Subsurface defects, which have been recently recognized to be industrially important, are characteristics deteriorating the electrical properties of semiconductor circuits.

The CMP process consists of some steps, i.e., a first polishing step for removing deep surface scratches, which requires a high polishing rate, and a second polishing step for removing microscratches remaining after the first polishing step and lowering the surface microroughness to the order of a few angstroms (Å) so as to have a specul ar surface. These polishing steps necessitate the use of a soft or hard urethane polishing cloth and a silica slurry as a polishing solution other than a polisher and deionized water.

Polishing of wafer surface can be explained by a reaction of chemical mechanical polishing. The polishing cloth is responsible for mechanical polishing and the polishing solution (slurry) assists in the mechanical polishing of the polishing cloth and plays a role in chemical polishing. A considerable improvement in performance of polishing cloths and slurries is required to produce high-quality large-diameter wafers.

Particularly, considering the processing characteristics of large-diameter (300 mm) wafers, it is important to develop slurries capable of achieving substantially defect-free surfaces.

Slurries are used to chemically and physically promote polishing in CMP processes. General slurries contain an abrasive, a base as a pH-adjusting agent, and deionized water. For better polishing, an organic or inorganic additive may be further added. Silica is mainly used as an abrasive, and potassium hydroxide, sodium hydroxide or ammonia water is generally used as a pH-adjusting agent. Nonionic surfactants, amine polishing accelerants, and the like are additionally used to increase the polishing rate, improve the degree of cleaning of polished surface and enhance the dispersibility of abrasives. It is common to select slurries corresponding to processing characteristics of CMP processes.

US 3,715,842 discloses a method for inhibiting aggregation and precipitation of silica to reduce the formation of scratches. According to this method, a slurry composition for final wafer polishing is prepared by dispersing settled silica particles having a size of 100 nm or less in water, adding ammonia to the dispersion to adjust the pH to 7 or higher, and adding a water-soluble cellulose selected from methylcellulose (MC), methylethylcellulose (MEC), ethylcellulose (EC), hydroxyethylcellulose (HEC) and hydroxypropylcellulose (HPC) in an amount of 0.05∼2.5% by weight, based on the total weight of the slurry. However, since the surface defects are simply detected by visual inspection using a microscope, there is a difficulty in clearly evaluating improvements in polishing quality.

US 4,169,337 discloses a slurry composition for reducing the occurrence of haze on the surface of a silicon wafer and increasing the polishing rate. The slurry composition is prepared by blending colloidal silica or silica gel having a size of 4∼100 nm as an abrasive with a water-soluble amine, e.g., aminoethylethanolamine or ethylenediamine, in an amount of 0.1∼5% by weight, based on the silica concentration. Further, US 4,462,188 proposes a composition comprising colloidal silica, a water-soluble amine, and a quaternary ammonium salt or a base thereof, e.g., tetramethylammonium chloride or tetramethylammonia hydroxide (TMAH), in an amount of 0.1∼5% by weight with respect to the silica concentration.

US 5,352,277 suggests a slurry composition for final wafer polishing which comprises colloidal silica, which has hydroxyl groups at a density of 8 group/nm² on the silica surface and an average particle diameter of 5-500 nm, 20-1,000 ppm of at least one water-soluble polymer selected from polyethyleneoxide, polyacrylamide and polyvinylpyrrolidone, which has a molecular weight of 100,000 or more, and a water-soluble salt consisting of a cation selected from Na, K and NH 4 and an anion selected from fluoride, chloride, nitrate and perchlorate. The slurry is used to realize a soft surface whose microroughness is below 5 nm. However, the polishing composition is within the general levels, and particularly, does not suggest improvements in light point defects (LPDs), haze and microroughness, but only an increased polishing rate.

These efforts to improve the polishing quality in terms of wafer slurries are limited. In recent years, extensive research has been conducted to enhance the polishing quality through optimization of various operational conditions for polishing processes.

US 6,189,546 proposes a polishing process for producing dopant-striation-free semiconductor wafers. The object of this process is to improve the production efficiency and enhance the polishing quality by operating one polisher in both primary polishing and secondary polishing. Particularly, in addition to a slurry, an etchant consisting of an amine (ethylamine, ethylenediamine or trimethylamine), an alkali base (KOH or NaOH) and an alkali salt (K₂CO₃, Na₂CO₃ or NaCl) is used to reduce the formation of dopant-striations in the primary polishing. Specifically, wafers are polished by the following three steps wherein a silica slurry (SYTON HT50) stabilized with sodium and an amine-containing alkaline etchant are simultaneously fed (first step), an amine-free alkaline etchant is fed simultaneously with the silica slurry (second step), and a silica slurry (GLANZOX3900 or GLANZOX3950) stabilized with ammonia and an alkaline etchant containing no amine are fed (third step). Further, the patent publication emphasizes that the wafers polished by the combination of the silica slurry stabilized with ammonia, the amine and the alkaline etchant have significantly fewer scratches, pits, and other surface defects. However, since the final quality of wafers is improved only by the first polishing without any change in the final polishing, it is difficult to distinguish the influence of the primary polishing from that of the final polishing.

US2002151252 relates to a polishing composition capable of efficiently preventing metal staining of an object to be polished. More particularly, it relates to a polishing composition which comprises (a) silicon dioxide, (b) at least one basic substance selected from the group consisting of an inorganic salt of an alkali metal, an ammonium salt, piperazine and ethylenediamine, (c) at least one chelating agent comprising several acid acetic and/or acetate functional groups.

WO2004042812 relates to a polishing composition for silicon wafer and a rinsing composition, both of which compositions can effectively suppress wafer contamination caused by metal impurities. In particular, it concerns polishing composition including a chelating agent, an alkali compound, silicon dioxide and water. The chelating agent is an acid comprising several phosphonic acid functional groups.

As discussed above, general slurries for polishing silicon wafers comprise colloidal silica as an abrasive, a polishing assistant selected from amines and organic and inorganic minerals, and a water-soluble polymer. In addition, general polishing processes are carried out through two steps, i.e. primary polishing and final polishing, or three steps, i.e. primarypolishing, secondary polishing and final polishing, using different kinds of slurries, polishers and polishing pads.

### Disclosure of Invention

### Technical Problem

It is an object of the present invention to provide a slurry for polishing a silicon wafer that exhibits superior characteristics in the design of high-performance semiconductors of the order of 65 nm or below. According to the slurry, the formation of large particles having a size of 0.5 microns is inhibited, and the formation of LPDs, haze and microroughness on the surface of a wafer is markedly reduced by making the particle size distribution of silica more uniform.

The polishing slurry of the present invention is a slurry for final polishing of a silicon wafer to remove surface defects. Thus, the present inventors developed a polishing slurry composition suited to reduce the surface microroughness and haze of silicon wafers wherein the size diameter of an abrasive is limited to 100 nm or less, the concentration of silica is controlled within the range of 0.2% to 10% by weight, and the pH value is adjusted to 9-11.5 so as to maintain a balance between mechanical polishing and chemical polishing effects.

### Technical Solution

In accordance with one aspect of the present invention, there is provided a polishing slurry composition comprising deionized water, colloidal silica, a pH-adjusting agent and a water-soluble thickening agent and a chelating agent.

characterized in that the chelating agent is a mixture of an acetate chelating agent and a phosphate chelating agent.

The polishing slurry composition of the present invention is characterized in that the water-soluble thickening agent is a water-soluble cellulose having a weight average molecular weight of 1,000,000∼4,000,000.

The polishing slurry composition of the present invention is characterized in that the acetate chelating agent is selected from the group consisting of ethylenediaminetetraacetic acid, diethylenetriaminepentaacetic acid, N-(hydroxyethyl)ethylenediaminetriacetic acid, nitrilotriacetic acid, salts thereof, and mixtures thereof.

The polishing slurry composition of the present invention is characterized in that the phosphate chelating agent is selected from the group consisting of sodium salt of ethylenediaminetetra(methylene phosphonic acid), ammonium salt of ethylenediaminetetra(methylene phosphonic acid), amino tri(methylene phosphonic acid), diethylenetriaminepenta(methylene phosphonic acid), and mixtures thereof.

The polishing slurry composition of the present invention is characterized in that the acetate chelating agent is added in an amount of 0.001∼0.5% by weight and the phosphate chelating agent is added in an amount of 0.0002∼5% by weight, based on the total weight of the slurry composition.

The polishing slurry composition of the present invention is characterized in that the mixing ratio of the phosphate chelating agent to the acetate chelating agent is in the range of 0.2:1 to 10:1.

The polishing slurry composition of the present invention is characterized in that when a mixture of the acetate chelating agent and the phosphate chelating agent is used, the acetate chelating agent is selected from EDTA, Na₄EDTA, Na₂EDTA, (NH₄)₄ EDTA and (NH₄)₂EDTA, and the phosphate chelating agent is selected from sodium salt of ethylenediamine tetra(methylene phosphonic acid) and ammonium salt of ethylenediaminetetra(methylene phosphonic acid).

In accordance with another aspect of the present invention, there is provided a method for polishing a silicon wafer using the polishing slurry composition by means of a single-wafer or multi-wafer polisher.

### Best Mode for Carrying Out the Invention

Hereinafter, the present invention will be explained in more detail.

The present invention provides a slurry composition for final polishing of a silicon wafer which comprises deionized water, a high-purity colloidal silica abrasive, a pH-adjusting agent, an acetate and a phosphate chelating agent, and a water-soluble thickening agent.

The colloidal silica abrasive is used to enhance the mechanical polishing power. The colloidal silica used in the present invention has an average diameter of 20-100 nm and preferably 30-80 nm in order to relatively reduce the mechanical polishing effects. When the colloidal silica has a particle diameter of less than 20 nm, sufficient mechanical polishing effects are not obtained and the silica particles may be unstable due to the presence of substances removed during polishing, which is thus undesirable. The unstable particles leave LPDs on the surface of a wafer, which may deteriorate the quality of the wafer. Meanwhile, when the colloidal silica has a particle diameter exceeding 100 nm, the polishing rate is high but surface or subsurface defects may be formed and thus the colloidal silica is unstable for final polishing.

The concentration of the silica is preferably between 0.075% and 15% by weight, and more preferably between 0.1% and 8% by weight. Such a low concentration makes the silica more dispersible, thus preventing the formation of aggregates having a size of 0.5 microns or above.

When the concentration of the silica is less than 0.075% by weight, a high polishing rate is not attained by the polishing method of the present invention. Meanwhile, when the concentration of the silica exceeds 15% by weight, the dispersion stability is poor and thus large amounts of aggregates having a size of 0.5 microns or above are undesirably formed.

The water-soluble thickening agent used in the present invention assists in the mechanical polishing effects. As the water-soluble thickening agent, a water-soluble cellulose, for example, hydroxyethylcellulose or hydroxypropylcellulose, can be used. Water-soluble celluloses are used to induce film formation or as slurry aggregates in paper-making and water-treatment industries. Water-soluble celluloses are used as silica-dispersion stabilizers in the art to which the present invention pertains. Particularly, the cellulose used in the present invention has a weight average molecular weight of 1,000,000∼4,000,000. When the concentration of the cellulose is in the range of 0.01∼2% by weight, the formation of LPDs on the surface of a silicon wafer can be reduced.

This result is due to three-dimensional crosslinking effects of the cellulose under the conditions of use of the thickening agent. Such three-dimensional crosslinking effects of the cellulose are assumed to sufficiently reduce collision and aggregation of the silica particles due to Brownian motion and to prevent modification of the silica aggregates into fme silica crystals.

For enhanced chemical polishing power, the pH value of the slurry is adjusted t 9-11.5 by the addition of at least one base selected from nitrogen bases, such as ammonia and amines, and metal hydroxides, such as NaOH and KOH. These bases can be used alone or in combination.

The present invention also provides a composition for polishing a silicon wafer comprising deionized water, colloidal silica, a pH-adjusting agent and a water-soluble thickening agent, characterized in that the composition comprises a mixture of an acetate chelating agent and an phosphate chelating agent.

The composition of the present invention comprises an acetate chelating agent, in addition to a basic composition for improving chemical mechanical polishing efficiency. The acetate chelating agent used herein prevents metal ion impurities from remaining on the surface of a wafer or diffusing into the subsurface of a wafer and to further improve the dispersion stability of the silica.

The acetate chelating agent is selected from the group consisting of ethylenediaminetetraacetic acid, diethylenetriaminepentaacetic acid, N-(hydroxyethyl)ethylenediaminetriacetic acid, nitrilotriacetic acid, salts thereof, and mixtures thereof.

The acetate chelating agent is preferably used in the range where the zeta potential of the slurry is unchanged. Preferably, the acetate chelating agent is used in an amount of 0.001∼0.5% by weight. When the acetate chelating agent is used below the lower limit, it does not affect the surface microroughness. Meanwhile, when the acetate chelating agent is used above the upper limit, the zeta potential is changed from a negative value to a positive value, which is undesirable in terms of dispersion stability.

Examples of the phosphate chelating agent used in the present invention include sodium salt of ethylenediaminetetra(methylene phosphonic acid), ammonium salt of ethylenediaminetetra(methylene-phosphonic acid), amino tri(methylene phosphonic acid), diethylenetriaminepenta(methylene phosphonic acid), and mixtures thereof.

Since the phosphate chelating agent used in the present invention has a structure similar to that of the acetate chelating agent, it can exhibit dispersion stability similar to that of the acetate chelating agent. However, it appears that there is a slight difference in terms of effects affecting the polishing quality between the phosphate chelating agent and the acetate chelating agent due to high etching power of the phosphate chelating agent. It is preferred to use the phosphate chelating agent in an amount of 0.0002∼5% by weight. When the phosphate chelating agent is used in an amount below the lower limit, there is no improvement in the polishing quality. Meanwhile, when the phosphate chelating agent is used in an amount above the upper limit, the surface microroughness is undesirably increased.

In the present invention, the acetate chelating agent and the phosphate chelating agent are simultaneously used. The use of EDTA salts, such as Na₄EDTA, Na₂ EDTA, (NH₄)₄EDTA, (NH₄)₂EDTA, and CaNA₂EDTA, as acetate chelating agents is particularly preferred because the surface microroughness is greatly reduced. The reduction in surface microroughness is assumed due to an ionic reaction between polar groups of the water-soluble polymer and the salts, which promotes the hydration of the polymer. As a result, the solubility is increased and the crosslinking of the polymer is improved, presumably leading to an improvement in the dispersion stability of the cellulose or the silica.

Particularly, the simultaneous use of the acetate chelating agent, such as EDTA, and the phosphate chelating agent further improves the dispersion stability of the silica, thus preventing an increase in the amount of large particles during long-term storage. At this time, it is preferred that the phosphate chelating agent be used in an amount of 0.2-10 times the amount of the EDTA. According to the composition, dispersion stability and storage stability are remarkably improved. In addition, improvements in surface microroughness and haze can be achieved.

The present invention also provides a method for polishing a silicon wafer using the polishing slurry composition by means of a single-wafer or multi-wafer polisher. By the method of the present invention, improvements in LPDs, haze and surface microroughness can be attained. Particularly, good results can be obtained when an etchant of an alkali base containing an amine is used together with the slurry in a single-wafer polisher. A polishing pad can be used in the polishing method of the present invention polishing. A hard polyurethane non-woven fabric can be used for primary polishing, and a soft polyurethane foam polishing cloth can be used for final polishing.

### Mode for the Invention

The effects of the present invention will now be explained in the following examples. However, these examples are not to be construed as limiting the scope of the invention.

Reference examples 1 to 3 and 5. Example 4.

Slurry compositions were prepared in accordance with the following procedure. First, based on the total weight of each of the slurry compositions, 5% by weight of colloidal silica having a silica particle size of 35-50 nm, 3% by weight of ammonia, 0.8% by weight of TMAH as a pH-adjusting agent, and 0.2% by weight of a hydroxypropylcellulose as a thickening agent were mixed together. Then, at least one additive in the amount indicated in Table 1 was added to the mixture to prepare the slurry compositions.

Each of the slurries was used to finally polish an 8" wafers (100, p-type), which were primarily polished using a Strasbaugh polisher (Syton HT50). After completion of the final polishing, the wafer surface characteristics, such as LPDs, haze and microroughness, were evaluated.

Specifically, the surface quality, such as LPDs and haze, was evaluated using a Surfscan SP-1 DLS (KLA-TENCOR), and the surface microroughness was evaluated using an interferometer (CHAPMAN). An accusizer, which is an apparatus for measuring the presence of large particles having a size of 0.5 microns or above, was used to evaluate the dispersion stability of the slurries.

Comparative Example 1

A polishing slurry composition was prepared by mixing 5% by weight of colloidal silica having a silica particle size of 35-50 nm, 3% by weight of ammonia, 0.8% by weight of TMAH as a pH-adjusting agent, and 0.2% by weight of a hydroxypropylcellulose as a thickening agent, based on the total weight of the slurry composition. The slurry composition was used for final polishing in the same manner as in Examples 1 to 5. After completion of the polishing, the wafer surface characteristics, such as LPDs, haze and microroughness, were evaluated. The results are shown in Table 1.

**Table 1**

| Example No. | Additional additive | | | | Change in amount of large particles² | Haze (ppm ) | LPD(≥0.08 □) | Rq³(Å) |
|---|---|---|---|---|---|---|---|---|
| | Acetate chelating agent | | Phosphate chelating agent | | | | | |
| | Kind | Content (%) | Kind | Content (%) | | | | |
| Ref Ex. 1 | EDTA | 0.1 | X | - | 1320 | 0.060 | 54 | 1.5 |
| Ref Ex. 2 | Na₄EDTA | 0.1 | X | - | 150 | 0.045 | 34 | 1.2 |
| Ref Ex. 3 | (NH₄)₄ED TA | 0.1 | X | - | 320 | 0.051 | 30 | 1.1 |
| Ex. 4 | (NH₄)₄ED TA | 0.1 | Na₂EDTMP | 0.16 A¹ | 30 | 0.038 | 14 | 1.0 |
| Ref Ex. 5 | X | - | Na₂EDTMP A | 0.16 | 420 | 0.043 | 29 | 1.2 |
| Comp. Ex. 1 | X | - | X | - | 1720 | 0.050 | 56 | 1.8 |

Note. ¹: Sodium salt of ethylenediaminetetra(methylene phosphonic acid)

²: Difference in the amount of large particles (≥ 0.5 □/mL) immediately after preparation and after 5 months of storage at room temperature

³: Surface microroughness (Rq) at a cut-off of 80□.

### Industrial Applicability

As apparent from the above description, the present invention provides a wafer polishing slurry composition comprising silica, deionized water, ammonia and a water-soluble cellulose, characterized in that the composition comprises at least one chelating agent selected from acetate chelating agents and phosphate chelating agents. The slurry composition of the present invention exhibits markedly improved storage stability. Particularly, when the slurry composition of the present invention is used for final polishing of a silicon wafer, the formation of haze, LPDs and surface microroughness on the surface of a wafer can be markedly reduced.

## Claims

1. A polishing slurry composition comprising deionized water, colloidal silica, a pH-adjusting agent a water-soluble thickening agent, and a chelating agent, wherein the chelating agent includes a mixture of an acetate chelating agent and a phosphate chelating agent.

2. The polishing slurry composition according to claim 1, wherein the water-soluble thickening agent is a water-soluble cellulose having a weight average molecular weight of 1,000,000-4,000,000.

3. The polishing slurry composition according to claim 1, wherein the acetate chelating agent is selected from the group consisting of ethylenediaminete- traacetic acid, diethylenetriaminepentaacetic acid, N- (hydroxyethyl)ethylenediaminetriacetic acid, nitrilotriacetic acid, salts thereof, and mixtures thereof.

4. The polishing slurry composition according to claim 1, wherein the phosphate chelating agent is selected from the group consisting of sodium salt of ethylenediaminetetra(methylene phosphonic acid), ammonium salt of ethylenediaminetetra(methylene phosphonic acid), amino tri(methylene phosphonic acid), diethylenetriaminepenta(methylene phosphonic acid), and mixtures thereof.

5. The polishing slurry composition according to claim 1, wherein the acetate chelating agent is present in an amount of 0.001-0.5% by weight and the phosphate chelating agent is present in an amount of 0.0002-5% by weight, based on the total weight of the slurry composition.

6. The polishing slurry composition according to claim 1, wherein the mixing ratio of the phosphate chelating agent to the acetate chelating agent is in the range of 0.2:1 to 10:1.

7. The polishing slurry composition according to claim 1, wherein the acetate chelating agent is selected from EDTA, Na₄EDTA, Na₂EDTA, (NH₄)₄EDTA and (NH₄)₂EDTA, and the phosphate chelating agent is selected from sodium salt of ethylenediamine tetra(methylene phosphonic acid) and ammonium salt of ethylenediaminetetra(methylene phosphonic acid).

8. A method for polishing a silicon wafer using the polishing slurry composition according to any one of claims 1 to 7 by means of a single- wafer or multi- wafer polisher.

## Patentansprüche

1. Poliersuspensionszusammensetzung umfassend deionisiertes Wasser, kolloidale Kieselsäure, ein Mittel zur pH-Einstellung, ein wasserlösliches Verdichtungsmittel und einen Chelatbildner, wobei der Chelatbildner eine Mischung eines Acetat-Chelatbildners und eines Phosphat-Chelatbildners umfasst

2. Poliersuspensionszusammensetzung nach Anspruch 1, wobei das wasserlösliche Verdichtungsmittel eine wasserlösliche Cellulose ist mit einem mittleren Molekulargewicht von 1,000,000 - 4,000,000.

3. Poliersuspensionszusammensetzung nach Anspruch 1, wobei der Acetat-Chelatbildner ausgewählt ist aus der Gruppe bestehend aus Äthylendiamintetraessigsäure, Diäthylentriaminpentaessigsäure, N-(Hydroxyäthyl)äthylendiamintetraessigsäure, Nitrilotriessigsäure, Salzen davon und Mischungen davon.

4. Poliersuspensionszusammensetzung nach Anspruch 1, wobei der Phosphat-Chelatbildner ausgewählt ist aus der Gruppe bestehend aus einem Natriumsalz der Äthylendiamintetra(methylenphosphonsäure), einem Ammoniumsalz der Äthylendiamintetra (methylenphosphonsäure), Aminotri(methylenphosphonsäure), Diäthylentriaminpenta (methylenphosphonsäure) und Mischungen davon.

5. Poliersuspensionszusammensetzung nach Anspruch 1, wobei der Acetat-Chelatbildner mit einem Anteil von 0.001 - 0.5 Gew.% vorhanden ist und der Phosphat-Chelatbildner mit einem Anteil von 0.0002 - 5 Gew.% vorhanden ist, bezogen auf das Gesamtgewicht der Polierzusammensetzung.

6. Poliersuspensionszusammensetzung nach Anspruch 1, wobei das Mischungsverhältnis von Phosphat-Chelatbildner zu Acetat-Chelatbildner im Bereich von 0.2:1 bis 10:1 liegt.

7. Poliersuspensionszusammensetzung nach Anspruch 1, wobei der Acetat-Chelatbildner ausgewählt ist aus EDTA, Na₄EDTA, Na₂EDTA, (NH₄)₄EDTA und (NH₄)₂EDTA und der Phosphat-Chelatbildner ausgewählt ist aus einem Natriumsalz der Äthylendiamintetra (methylenphophonsäure) und einem Ammoniumsalz der Äthylendiamintetra(methylenphosphonsäure).

8. Verfahren zum Polieren eines Siliciumwafers unter Verwendung der Poliersuspensionszusammensetzung nach einem der Ansprüche 1 bis 7 mit Hilfe einer Einzelwafer- oder Multiwafer-Poliermaschine.

## Revendications

1. Composition de pâte de polissage comprenant de l'eau déminéralisée, de la silice colloïdale, un agent d'ajustement de pH, un épaississant soluble dans l'eau et un agent chélateur, dans laquelle l'agent chélateur inclut un mélange d'un agent chélateur acétate et un agent chélateur phosphate.

2. Composition de pâte de polissage selon la revendication 1, dans laquelle l'épaississant soluble dans l'eau est une cellulose soluble dans l'eau présentant une masse moléculaire moyenne en poids de 1 000 000 à 4 000 000.

3. Composition de pâte de polissage selon la revendication 1, dans laquelle l'agent chélateur de l'acétate est choisi parmi le groupe constitué de l'acide éthylènediaminetétraacétique, de l'acide diéthylènetriamine-pentaacétique, de l'acide N-(hydroxyéthyl)éthylènediamine-triacétique, de l'acide nitrilotriacétique, de sels de ceux-ci et de mélanges de ceux-ci.

4. Composition de pâte de polissage selon la revendication 1, dans laquelle l'agent chélateur phosphate est choisi parmi le groupe constitué d'un sel de sodium d'acide éthylènediaminetétra (méthylène phosphonique), d'un sel d'ammonium d'acide éthylènediaminetétra (méthylène phosphonique), d'un acide amino tri(méthylène phosphonique), d'un acide diéthylènetriaminepenta (méthylène phosphonique), et de mélanges de ceux-ci.

5. Composition de pâte de polissage selon la revendication 1, dans laquelle l'agent chélateur acétate est présent en une quantité de 0,001 à 0,5 % en poids et l'agent chélateur phosphate est présent en une quantité de 0,0002 à 5 % en poids, sur la base du poids total de la composition de pâte.

6. Composition de pâte de polissage selon la revendication 1, dans laquelle le rapport de mélange de l'agent chélateur phosphate sur l'agent chélateur acétate est dans la plage de 0,2:1 à 10:1.

7. Composition de pâte de polissage selon la revendication 1, dans laquelle l'agent chélateur acétate est choisi parmi EDTA, Na₄EDTA, Na₂EDTA, (NH₄)₄EDTA, et (NH₄)₂EDTA, et l'agent chélateur phosphate est choisi parmi le groupe constitué d'un sel de sodium d'acide éthylènediaminetétra(méthylène phosphonique), et d'un sel d'ammonium d'acide éthylènediaminetétra(méthylène phosphonique).

8. Procédé pour polir une galette de silicium en utilisant la composition de pâte de polissage selon l'une quelconque des revendications 1 à 7 au moyen d'un polisseur de galette unique ou multi-galettes.
